# FASCICULE DE BREVET EUROPEEN

(11) **EP 1 970 950 B1**
(45) Date de publication et mention de la délivrance du brevet: **18.06.2014**
(21) Numéro de dépôt: 08102290.7
(22) Date de dépôt: 05.03.2008
(51) Int. Cl.: H01L 21/768, H01L 23/522, H01L 23/532

(54) **Procédé de fabrication d'une structure d'interconnexions à cavités d'air pour circuit intégré**
Verfahren zur Herstellung einer Leiterstruktur mit luftgefüllten Zwischenräumen für integrierten Schaltkreis
Method of manufacturing an interconnection structure with air gaps for an integrated circuit

(30) Priorité: 16.03.2007 FR 0753885
(43) Date de publication de la demande: 17.09.2008
(73) Titulaire: Commissariat à l'Énergie Atomique et aux Énergies Alternatives, 75015 Paris (FR)
(72) Inventeur: Gaillard, Frédéric-Xavier, 38500, Voiron (FR)
(74) Mandataire: Ahner, Philippe

(56) Documents cités:
- US-A1- 2004 087 133
- US-A1- 2005 037 604
- US-A1- 2006 006 538
- US-A1- 2006 216 920
- SCHULZE K ET AL: "Formation of air gap structures via wet etch removal of sacrificial dielectrics", ADVANCED METALLIZATION CONFERENCE. PROCEEDINGS OF THE CONFERENCE, XX, XX, 2005, pages 309-316, XP008084926,
- GAILLARD F ET AL: "Chemical etching solutions for air gap formation using a sacrificial oxide/polymer approach", MICROELECTRONIC ENGINEERING ELSEVIER NETHERLANDS, vol. 83, no. 11-12, novembre 2006 (2006-11), pages 2309-2313, XP002455759, ISSN: 0167-9317

## Description

### DOMAINE TECHNIQUE

L'invention se rapporte à un procédé de fabrication d'une structure d'interconnexions à cavités pour circuit intégré.

### ÉTAT DE LA TECHNIQUE ANTÉRIEURE

L'introduction de cavités d'air (ou « Air Gap » en anglais) dans une structure d'interconnexions est aujourd'hui envisagée pour les générations ultérieures au noeud technologique 32 nm. Son utilisation dans des structures d'interconnexions permettra ainsi d'assurer les performances électriques nécessaires qui sont imposées par la réduction continue des dimensions entre lignes de cuivre et diélectriques (miniaturisation des composants). Cette approche consiste à remplacer l'utilisation actuelle de matériau diélectrique entre les lignes de conducteurs (cuivre ou aluminium) par des cavités d'air de permittivité égale à 1.

Pour les générations de circuits actuels, les matériaux diélectriques poreux de faible permittivité (constante diélectrique de l'ordre de 2,3 à 2,7 présentent des caractéristiques suffisantes pour remplacer les oxydes de silicium comme isolants. Néanmoins, les efforts de développement qui sont engagés sur la recherche de nouveaux matériaux ne justifient pas nécessairement le gain de quelques dixièmes d'unité sur les futures valeurs de constante diélectrique. En remplaçant le matériau isolant par de l'air (concept « Air Gap »), une avancée technologique majeure est envisagée.

A ce jour, deux types d'approches ont largement été décrits. La première dite du « dépôt non-conforme » consiste à déposer un matériau diélectrique donné sur des tranches d'interlignes métalliques. Des contraintes d'intégration sont alors exigées telles que le rapport « hauteur sur largeur de ligne » défini, une étape supplémentaire de lithographie, une fabrication de masque dédié qui représente un coût prohibitif pour une approche industrielle. On peut se référer à ce sujet à l'article « General review of issues and perspectives for advanced copper interconnexions using air gaps as ultra low-k materials » de L. G. GOSSET et al., Proceedings of the IEEE 2003 International Interconnect Technology Conference, (2003), 65.

La deuxième approche utilise un matériau sacrificiel intercalé entre plusieurs tranches de matériaux diélectriques ; ce matériau est extrait après intégration au moyen de procédés physico-chimiques divers : recuit thermique, traitement par rayonnement. On peut se référer à ce sujet à l'article « Benefits and Trade-offs in Multi-Level Air Gap Integration » de R. J. O. M. HOOFMAN et al., Spring MRS, San Diego, Etats-Unis, avril 2006. L'extraction peut aussi être obtenue par attaque chimique comme le divulgue le document FR-A-2 851 373 (correspondant à la demande américaine 2004/229 454).

L'objectif de cette approche est de « monter » une intégration sur plusieurs niveaux d'interconnections avec le matériau sacrificiel puis de libérer les cavités d'air lorsque la structure est finalisée. Les intérêts industriels sont aujourd'hui focalisés sur cette dernière approche. Malheureusement, et quelle que soit l'approche considérée (attaque chimique ou dégradation thermique), le développement de nouveaux matériaux (membrane poreuse ou matériau thermiquement dégradable respectivement) reste nécessaire, ce qui ne permet pas d'envisager une intégration fiable à moyen terme.

D'autres part, des problèmes spécifiques à chacune des approches peuvent être détaillés de la façon suivante. Dans l'approche décrite dans le document FR-A-2 851 373, le matériau sacrificiel est en oxyde de silicium et la solution d'attaque utilisée est une solution d'acide fluorhydrique. Dans ce cadre, l'impact de la solution chimique sur la structure d'interconnexions et notamment sur les lignes métalliques (corrosion du cuivre, dissolution des barrières de diffusion, formation de complexes fluorés, effet galvanique...) ou les matériaux en présence (membrane poreuse, traitement d'adhérence notamment) ne sont pas négligeables.

De même, pour les matériaux thermiquement dégradés (voir l'article de R. J. O. M. Hoofman), leur intégration nécessite le développement complet de nouveaux diélectriques compatibles « Back-End of line », ce qui rend le travail de développement considérable (matériau thermiquement dégradable stable à une certaine température et totalement décomposée à une autre, et devant être compatible avec les températures de recuit du cuivre ou du matériau utilisé au niveau traversées par exemple...). De plus, ce matériau dégradable doit être décomposé avec un rendement proche de 1, et les résidus de la décomposition doivent être efficacement évacués à travers la membrane utilisée au niveau traversées pour assurer des performances électriques satisfaisantes (courant de fuite, capacité...) et stables dans le temps.

Le document US 2004/0087133 décrit un procédé de fabrication d'une structure d'interconnexions électriques, comprenant des conducteurs électriques disposés sur un substrat et séparés entre eux par des cavités d'air. Ce procédé comprend (i) le dépôt d'un couche de matériau sacrificiel sur le substrat, (ii) la gravure du matériau sacrificiel pour ne conserver que les portions où les cavités d'air doivent être formées, (iii) le dépôt d'une couche à faible constante diélectrique, (iv) la gravure de la couche à faible constante diélectrique selon un motif correspondant aux conducteurs électriques, (v) avant ou après l'étape (iv) le retrait des portions pour les cavités d'air, et (v) la formation des conducteurs électriques dans le motif de gravure.

### EXPOSÉ DE L'INVENTION

L'invention présente un nouveau procédé pour réaliser des cavités d'air sur des multi-niveaux dans une structure d'interconnexions. Ce procédé a l'avantage, pour l'industrie de la microélectronique, de permettre d'utiliser des matériaux et procédés déjà intégrés et donc acceptés dans les unités de fabrication, mais également d'être compatible avec les noeuds et donc dimensions des technologies concernées. Le principe de base consiste à réaliser les cavités d'air délimitées par une membrane avant le dépôt métallique de la ligne en question. La membrane est alors formée selon les dessins du masque et suffisamment rigide pour se maintenir d'elle-même en place après formation des cavités.

L'invention a donc pour objet un procédé de fabrication d'une structure d'interconnexions électriques de type damascène pour un circuit intégré, comprenant au moins un niveau d'interconnexions, constitué de conducteurs électriques disposés sur un substrat et séparés entre eux par des cavités d'air, une couche de matériau électriquement isolant recouvrant le niveau d'interconnexions, le procédé comprenant les étapes consistant à :
- déposer une couche de matériau sacrificiel sur le substrat,
- graver la couche de matériau sacrificiel selon un motif correspondant aux conducteurs électriques,
- déposer, sur la surface gravée de la couche de matériau sacrificiel, une couche de membrane en matériau perméable à un agent d'attaque permettant de décomposer le matériau sacrificiel,
- décomposer le matériau sacrificiel au moyen de l'agent d'attaque, moyennant quoi des cavités d'air sont formées à la place du matériau sacrificiel décomposé,
- former les conducteurs électriques dans le motif de gravure pour obtenir des conducteurs électriques séparés par les cavités d'air,
- déposer une couche de matériau électriquement isolant pour recouvrir le niveau d'interconnexions obtenu.

Le procédé peut comprendre en outre une étape consistant à déposer, avant l'étape de gravure du matériau sacrificiel, une couche de consolidation de membrane en un matériau plus dense que la couche de membrane, qui est gravé lors de l'étape de gravure et qui n'est pas décomposé par l'agent d'attaque. Il peut alors comprendre en outre une étape consistant à déposer, avant l'étape de gravure du matériau sacrificiel, une couche d'un matériau masque sur la couche de consolidation de membrane.

Si le procédé comprend une étape de dépôt d'une couche de consolidation de membrane, il peut aussi comprendre, après l'étape de dépôt de la couche de membrane en matériau poreux et avant l'étape de formation des conducteurs électriques, une étape consistant à éliminer les parties de la couche en matériau poreux situées au fond des zones gravées et sur les parties non gravées de la couche de matériau sacrificiel.

L'étape de formation des conducteurs électriques peut comprendre :
- une étape de dépôt d'une couche d'un matériau électriquement conducteur avec remplissage du motif de gravure,
- une étape de polissage mécano-chimique menée jusqu'à révéler la couche de consolidation de membrane.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1E sont des vues explicatives d'un premier mode de mise en oeuvre du procédé selon la présente invention,
- les figures 2A à 2F sont des vues explicatives d'un deuxième mode de mise en oeuvre du procédé selon la présente invention,
- la figure 3 est une vue d'une structure obtenue par le procédé de la présente invention, avant l'étape de retrait du matériau sacrificiel,
- les figures 4 à 7 sont des vues de différentes structures obtenues par le procédé de la présente invention, après l'étape de retrait du matériau sacrificiel et en fonction de différentes caractéristiques de la membrane,
- les figures 8A à 8U illustrent un procédé de fabrication d'une structure d'interconnexions à cavités pour circuit intégré selon un mode préférentiel de l'invention.

### EXPOSÉ DÉTAILLÉ DE MODES DE RÉALISATION PARTICULIERS

Dans la suite de la description, on utilisera l'expression « cavité d'air » pour traduire l'expression consacrée en anglais « air gap » bien que ces cavités puissent être remplies par un autre gaz ou être vides de gaz.

De la même façon que pour les approches préalablement décrites, le procédé de l'invention s'appuie sur l'utilisation d'un matériau sacrificiel pouvant être dégradé soit par voie chimique, l'exemple le plus connu concernant la dissolution des combinaisons de SiO₂ telles que USG (pour « Undoped Silicate Glass ») ou FSG (pour « Fluorinated Silicate Glass ») par une solution d'acide fluorhydrique, soit par voie thermique, par décomposition d'un matériau type PMMA, poly-méthylmétacrylate, matériau décomposable à 300°C, ou soit par plasma. La route d'intégration du SiO₂ par voie chimique est préférée car classiquement connue puisque étant intégrée dans les technologies anciennes (noeuds 120 nm, années 90). Cette intégration permet notamment de conserver l'intégrité et un profil acceptable des lignes lors de la phase de gravure (peu ou pas de courbure) et constitue donc un avantage remarquable pour l'approche.

La réalisation de ces cavités d'air consiste alors:
- A réaliser un dépôt sur un substrat adapté, d'une couche de matériau sacrificiel (SiO₂, polymère, silicium...) d'épaisseur intéressant le noeud technologique concerné par ce type d'approche.
- A « construire » l'intégration (réalisation des motifs pour la formation des lignes métalliques) selon les procédés classiques de la microélectronique (dépôt de masque dur, lithographie, gravure, élimination de résine, nettoyage...).
- A déposer la membrane perméable au procédé d'attaque, d'épaisseur pouvant aller jusqu'à 50 nm et qui supportera l'ensemble de la structure formée sur les cavités d'air. On entend par perméable le fait que la membrane puisse laisser diffuser l'agent utilisé pour attaquer la couche sacrificielle ainsi que les constituants issus de la décomposition. Ce dépôt peut être réalisé en deux temps selon les besoins de l'intégration. Dans ce dernier cas, la « membrane » serait composée par deux dépôts: un premier dépôt de matériau non poreux à la solution d'attaque ou étanche ou avec une sélectivité « vitesse de diffusion dans la couche par rapport à la vitesse de décomposition de la couche sacrificielle » élevée. Ce dépôt est réalisé avant l'étape de gravure. Un second dépôt de matériau perméable du même type est réalisé sur les flancs après lithographie puis gravure. Par matériau perméable, on entend un matériau qui laisse diffuser la solution d'attaque sur toute son épaisseur, par exemple un matériau tel que le SiLK^{™} (déposé par plasma), le SiC (déposé par plasma en faible épaisseur (moins de 40 nm, par exemple entre 7 et 10 nm) par exemple en utilisant des précurseurs), un matériau poreux (aluminium poreux, silicium poreux, SiC poreux, SiON) ou rendus poreux au moyen d'un procédé électrochimique ou en modifiant les conditions de dépôt.

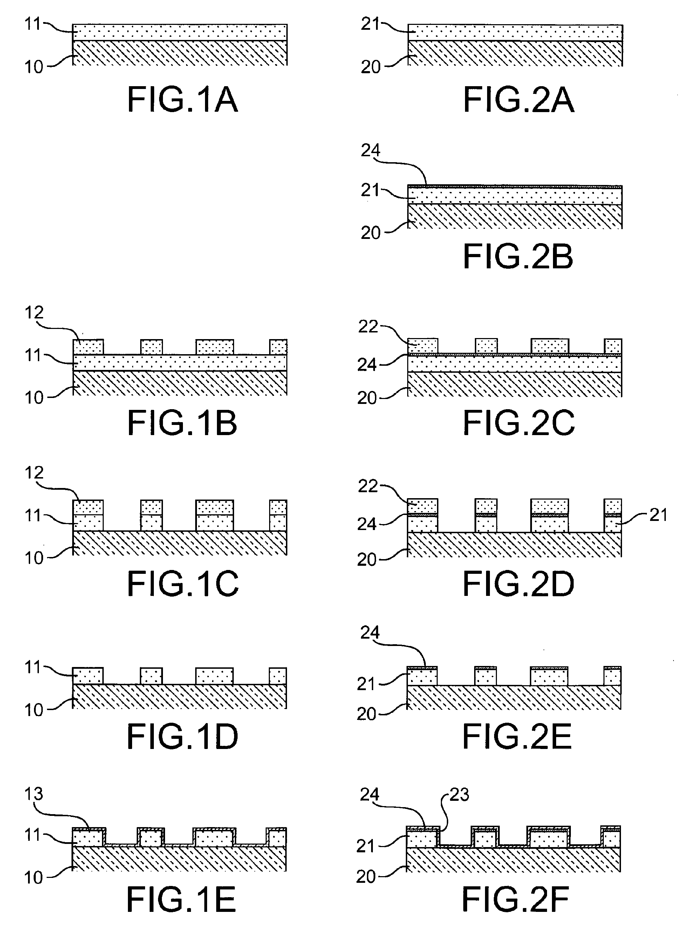

Les figures 1A à 1E sont des vues explicatives d'un premier mode de mise en oeuvre du procédé selon l'invention.

La figure 1A montre un substrat 10 dont la constitution n'a pas besoin d'être détaillée pour l'explication du procédé. Sur le substrat 10, on dépose une couche de matériau sacrificiel 11, par exemple une couche de SiO₂, par une technique bien connue de l'homme de l'art.

On procède ensuite aux étapes classiques de l'intégration :
- définition d'un motif d'interconnexion par un procédé de lithographie utilisant une couche de résine 12 ou un masque dur sur la couche sacrificielle 11 (voir la figure 1B),
- gravure de la couche sacrificielle 11 au travers du masque 12 jusqu'à révéler le substrat 10 (voir la figure 1C),
- élimination (ou « stripping ») du masque (voir la figure 1D).

On dépose alors sur la structure obtenue une membrane poreuse 13 (voir la figure 1E). La membrane 13 épouse la face supérieure de la structure en englobant le matériau sacrificiel subsistant.

Les figures 2A à 2F sont des vues explicatives d'un deuxième mode de mise en oeuvre du procédé selon l'invention.

La figure 2A montre un substrat 20 dont la constitution n'est pas détaillée. Comme pour le premier mode de réalisation, on dépose une couche de matériau sacrificiel 21, par exemple une couche de SiO₂. Sur la couche sacrificielle 21, on dépose une première couche de membrane 24 en matériau non poreux (voir la figure 2B).

On procède ensuite aux étapes classiques de l'intégration :
- définition d'un motif d'interconnexion par un procédé de lithographie utilisant une couche de résine 22 ou un masque dur sur la première couche de membrane 24 (voir la figure 2C),
- gravure de la première couche de membrane 24 et de la couche sacrificielle 21 au travers du masque 22 jusqu'à révéler le substrat 20 (voir la figure 2D),
- élimination du masque, révélant des parties subsistantes de matériau sacrificiel 21 recouvertes du matériau non poreux 24 (voir la figure 2E).

On dépose alors sur la structure obtenue une deuxième couche de membrane 23 en matériau poreux (voir la figure 2F). La deuxième couche de membrane 23 épouse la face supérieure de la structure en englobant le matériau sacrificiel subsistant et la partie subsistante de la première couche de membrane. On obtient donc une membrane en deux temps, constituée de l'association de parties de la première couche de membrane et de la deuxième couche de membrane.

Les propriétés de cette membrane constituent le point clé de l'invention : elle doit être suffisamment rigide pour se maintenir d'elle-même selon les motifs dessinés sur le masque de lithographie et en fonction des zones où les cavités ont été effectivement réalisées. En effet, selon les modes de réalisation et les procédés de retrait retenus, le retrait du matériau sacrificiel sera total ou partiel, ce qui permettra de consolider ou non la structure (notamment sur les zones dites relâchées (motifs larges), le problème ne se posant pas pour les motifs étroits comme on le montrera plus loin. On rappelle que le cas des motifs étroits correspond aux zones où la cavité d'air est requis pour assurer les performances des circuits intégrés.

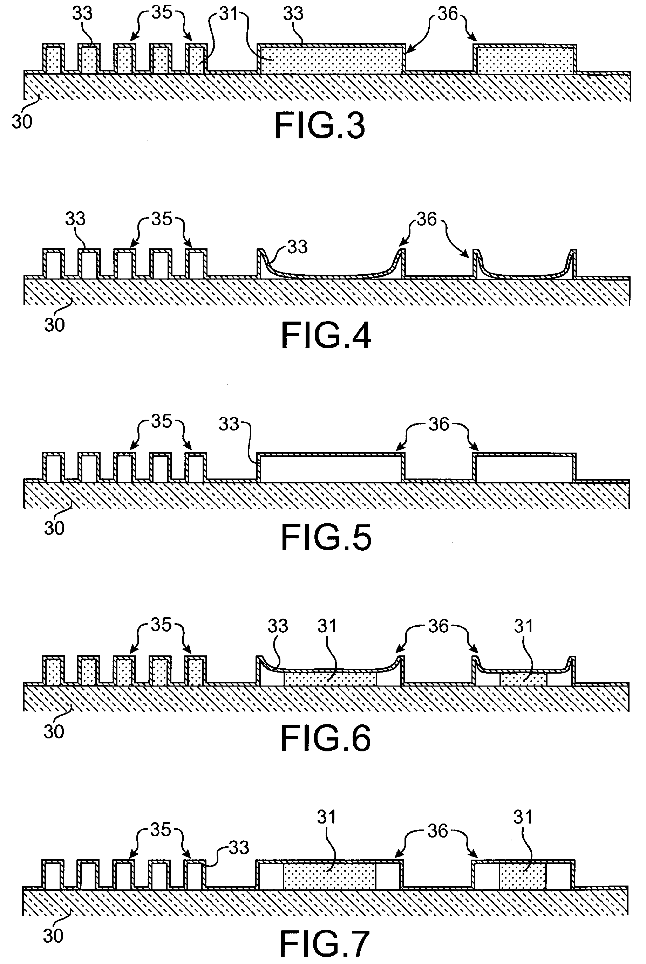

On va maintenant expliquer les propriétés recherchées pour la membrane en se référant aux figures 3 à 7.

La figure 3 montre une structure réalisée à partir d'un substrat 30 par le procédé de l'invention et avant le retrait du matériau sacrificiel 31. La structure comporte deux types de motifs retenant du matériau sacrificiel 31 entre la membrane 33 et le substrat 30 : les motifs étroits 35 et les motifs larges 36. On entend par motif étroit un motif tel que ses dimensions ne produisent pas d'effet dit de « collapse » (collage des motifs) lors de l'étape de retrait de la couche sacrificielle. Cet effet dépend en particulier du module d'Young de la membrane et des conditions du procédé de séchage.

Les figures 4 à 7 montrent les résultats obtenus après l'étape de retrait du matériau sacrificiel et en fonction de différentes caractéristiques de la membrane.

La figure 4 illustre le cas d'un retrait du matériau sacrificiel dans la totalité du volume englobé par la membrane 33. Cette figure montre un cas où la membrane 33 ne se maintient pas dans les motifs larges 36. La membrane se colle au substrat 30 dans les zones de motifs larges. Ce problème peut être lié à un manque de rigidité de la membrane. Il peut aussi être lié au procédé de retrait utilisé et imputable aux forces de tension de surface induites lors du séchage de la structure par exemple. Le cas illustré par la figure 4 ne convient pas pour des motifs larges.

La figure 5 illustre le cas d'un retrait du matériau sacrificiel dans la totalité du volume englobé par la membrane 33. Cette figure montre un cas où la membrane 33 se maintient aussi bien dans les motifs étroits 35 que dans les motifs étroits 36. La membrane ne colle pas au substrat parce qu'elle est suffisamment rigide pour ne pas se déformer.

La figure 6 illustre le cas d'un retrait partiel du matériau sacrificiel : le matériau sacrificiel n'est pas retiré sur la totalité du volume par la membrane 33. Il est retiré partiellement sur la hauteur dans les motifs 36. Ce cas est à éviter parce qu'il peut poser problème suite au dépôt postérieur d'interconnexions.

La figure 7 illustre le cas d'un retrait partiel du matériau sacrificiel 31. Le matériau sacrificiel n'est pas retiré sur la totalité du volume. Le retrait ne se fait que sur les flancs. Ceci peut être dû à la méthode de dépôt de la membrane 33. Un dépôt non isotrope de la membrane peut entraîner une épaisseur de membrane plus faible sur les flancs des motifs que sur les sommets, ce qui rend plus facile la diffusion de l'agent d'attaque selon une direction donnée. Ce cas résulte d'un bon compromis et peut être avantageusement recherché dans le cas de motifs larges.

L'idée de déposer la membrane en deux temps peut être retenue pour privilégier la zone où les cavités seront préférentiellement formées et pour favoriser plus particulièrement la configuration décrite à la figure 7, cas le plus favorable pour une consolidation de la structure.

Les autres propriétés requises pour la mise en oeuvre de l'invention sont principalement :
- le fait de pouvoir déposer le matériau sur des structures gravées, ce qui implique des procédés de dépôt par exemple de type PECVD et non de type par rotation (ou dépôt « spin-on ») ;
- la diffusion possible de l'agent d'attaque et des résidus issus de la réaction chimique ou de la décomposition du matériau sacrificiel (thermique ou par plasma...) afin de préserver les propriétés électriques.

Les matériaux les plus intéressants aujourd'hui pour ce type d'application sont typiquement les matériaux SiC qui, en fonction des précurseurs utilisés, permettent pour le même type de dépôt d'obtenir une couche plus ou moins poreuse à une solution d'acide fluorhydrique (sélectivité en termes de vitesse de diffusion des solutions dans la couche selon ces caractéristiques. Par exemple, le SiC dit « Karha » est imperméable, dans les gammes d'épaisseur utilisées actuellement en « Back-End », à une solution d'acide fluorhydrique en phase vapeur alors que le SiC DMPS (SiC diméthylphénylsilane) est perméable à cette solution. L'utilisation conjointe de ces dépôts permet la réalisation de ce type d'applications. Certains polymères organiques à base de carbone et d'hydrogène sont étanches à l'acide fluorhydrique en vapeur et peuvent également être utilisés dans ce type d'application.

Comme autres propriétés requises, on peut aussi mentionner :
- le retrait du matériau sacrificiel par les divers procédés préalablement décrits (thermique, chimique, plasma...)
- la possibilité d'effectuer une étape de métallisation (barrière de diffusion ou non, dépôt d'un matériau conducteur de type cuivre, polissage mécano-chimique, dépôt de barrière autopositionnée si nécessaire...).

Ces propriétés doivent être reproduites sur les niveaux supérieurs autant de fois que nécessaire.

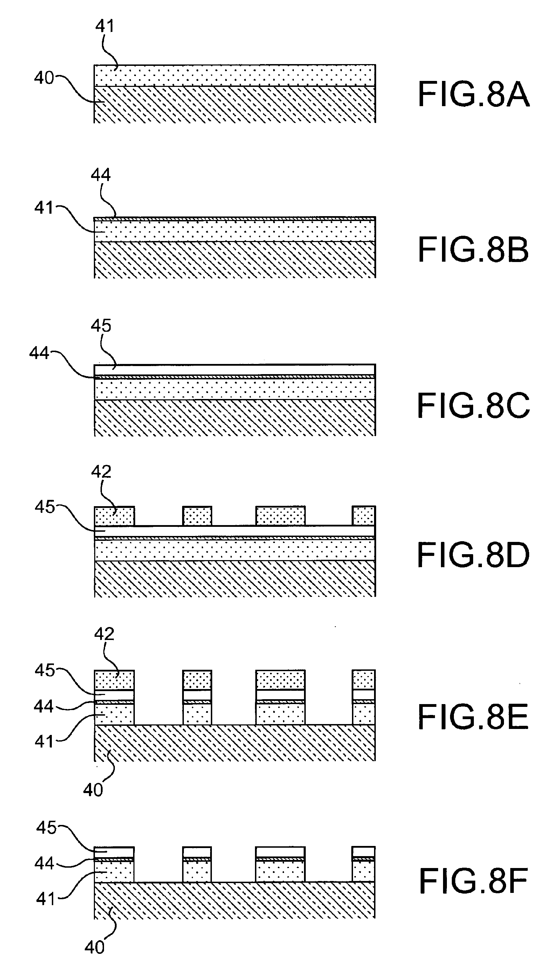

Les figures 8A à 8U illustrent un procédé de fabrication d'une structure d'interconnexions à cavités pour circuit intégré selon un mode préférentiel de l'invention. Il s'agit d'un mode de réalisation où l'on cherche à éviter l'effondrement de la membrane (si celle-ci ne possède pas les qualités de rigidité requises) lors de la libération des cavités d'air (cas illustré par la figure 7). Il s'agit actuellement de l'exemple le plus réaliste. Les figures 8A à 8H montrent les étapes successives de l'intégration pour la réalisation de cavités d'air au premier niveau de métal dans le cadre de l'utilisation de SiO₂ comme matériau sacrificiel.

La figure 8A montre un substrat 40 dont la constitution n'est pas détaillée. On dépose, sur le substrat 40, une couche de matériau sacrificiel 41 constitué de SiO₂ d'épaisseur pouvant aller jusqu'à 400 nm, avantageusement comprise entre 50 et 150 nm, par exemple entre 80 et 120 nm.

Au-dessus de la couche de matériau sacrificiel 41, on dépose une couche 44 d'un matériau qui peut être poreux ou perméable, par exemple un matériau du type SiC, d'une épaisseur pouvant aller jusqu'à 60 nm (voir la figure 8B). L'intérêt d'utiliser un matériau dense, et donc imperméable, à la solution chimique d'attaque (matériau de type SiC Karha), est qu'il permet de localiser les cavités d'air et de conserver ainsi une certaine rigidité de structure pour les motifs larges. Ceci permet d'éviter les problèmes d'effondrement et de localiser les cavités d'air sur les zones denses. La route classique d'intégration, connue de l'homme du métier, est alors effectuée.

La figure 8C montre la structure obtenue après le dépôt d'une couche 45 d'un matériau formant masque dur sur la couche 44. La couche 45 peut être une couche de carbone amorphe, de TiN ou d'oxyde de silicium surmonté d'une couche de TiN et avoir jusqu'à 60 nm d'épaisseur, avantageusement jusqu'à 40 nm d'épaisseur.

Les figures 8D à 8F illustrent les étapes classiques de l'intégration :
- lithographie d'une couche de résine 42 (voir la figure 8D),
- gravure de la couche 45 de matériau formant masque dur, de la couche 44 de SiC et de la couche de matériau sacrificiel 41 jusqu'à révéler le substrat 40 (voir la figure 8E),
- élimination du masque de résine, révélant des parties subsistantes du matériau sacrificiel 41 recouvertes successivement du matériau de type SiC 44 et du matériau formant masque dur 45 (voir la figure 8F).

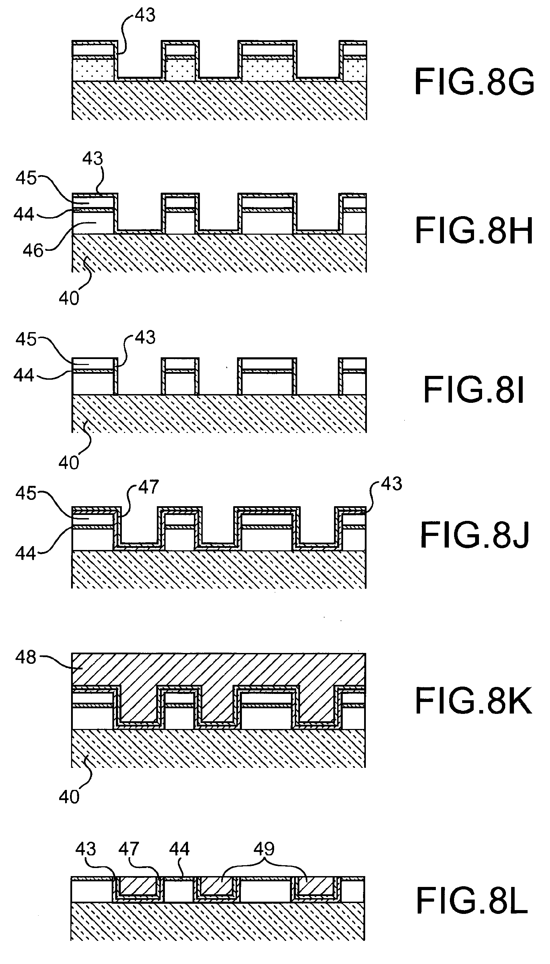

On dépose alors sur la structure obtenue une couche 43 en matériau poreux à l'agent de retrait (voir la figure 8G). Le matériau poreux de la couche 43 a non seulement la propriété de pouvoir laisser diffuser l'agent chimique à travers la couche 43, mais aussi la propriété de laisser diffuser les résidus issus de la réaction. A titre d'exemple, la couche 43 peut être en SiC DMPS et avoir jusqu'à 40 nm d'épaisseur et avantageusement jusqu'à 10 nm d'épaisseur pour un agent de retrait constitué d'une solution d'acide fluorhydrique.

La membrane comprend donc plusieurs couches : les parties subsistantes de la couche 44, les parties subsistantes de la couche 45 et la couche 43.

La figure 8H montre la structure obtenue après le retrait du matériau sacrificiel. La couche 43 renferme les futures cavités d'air 46.

La partie de matériau poreux de la couche 43 déposée en fond de ligne, c'est-à-dire sur le substrat 40 ou ultérieurement en fond de traversées (dans le cadre de l'intégration multi-niveaux), peut être éliminées sans conséquence néfaste sur la structure. Cette étape peut se faire avant ou après la réalisation des cavités d'air. La figure 8I représente la structure obtenue après élimination du matériau poreux de la couche 43 en fond de lignes.

Après l'étape de libération de la membrane, un dépôt métallique pour les futures lignes de connexion peut être réalisé selon une route classique, c'est-à-dire que l'on procède au dépôt d'une barrière de diffusion 47 sur la structure obtenue précédemment comme le montre la figure 8J. On remarquera que la structure de la figure 8J correspond au cas où le matériau poreux de la couche 43 est conservée en fond de ligne. La barrière de diffusion 47 peut être du type Ta/TaN et avoir entre 1 et 20 nm d'épaisseur, par exemple entre 15 et 20 nm d'épaisseur.

L'un des avantages du procédé selon l'invention par rapport au procédé décrit dans le document FR-A-2 851 373 est que ni la barrière de diffusion, ni le dépôt métallique destiné à constituer les lignes de connexion ne sont soumis à aucun moment à la solution d'attaque chimique de la couche sacrificielle. Ceci implique qu'avec la diminution des dimensions, et par conséquent la réduction de l'épaisseur des matériaux utilisés (notamment en ce qui concerne les barrières de diffusion), la « criticité » de l'approche avec l'évolution des noeuds technologiques serait minimisée.

On procède ensuite au dépôt d'une couche de cuivre 48 suffisamment épaisse pour combler les zones en creux de la structure (voir la figure 8K). Le dépôt de cuivre est réalisé par dépôt électrochimique ECD ou par dépôt PVD.

La figure 8L montre la structure obtenue avec une étape de planarisation mécano-chimique. Cette étape a été menée de façon à ne laisser subsister en fermeture des cavités d'air que la couche 44. Les lignes de cuivre 49 sont chemisées successivement par la couche barrière 47 et la couche de matériau poreux 43.

On a ainsi réalisé un premier niveau de connexions. La réalisation d'un deuxième niveau ou d'autres niveaux de connexions peut être envisagée sur le même principe.

Le niveau de métallisation supérieur (niveau traversées ou vias) est alors constitué d'un matériau diélectrique par exemple de type méthylsilsesquioxane (MSQ), matériau hybride entre SiO₂ et polymère organique. On peut également citer des polymères organiques incluant, entre autres, les polynorbomènes, les polyimides photosensibles, les polyarylènes tels que le SiLK^{™} ou le GX-3^{™}, les polyaryléthers tels que le FLARE^{™}. L'intégration du deuxième niveau de métal est appliquée avec du SiO₂ selon la route « double damascène ».

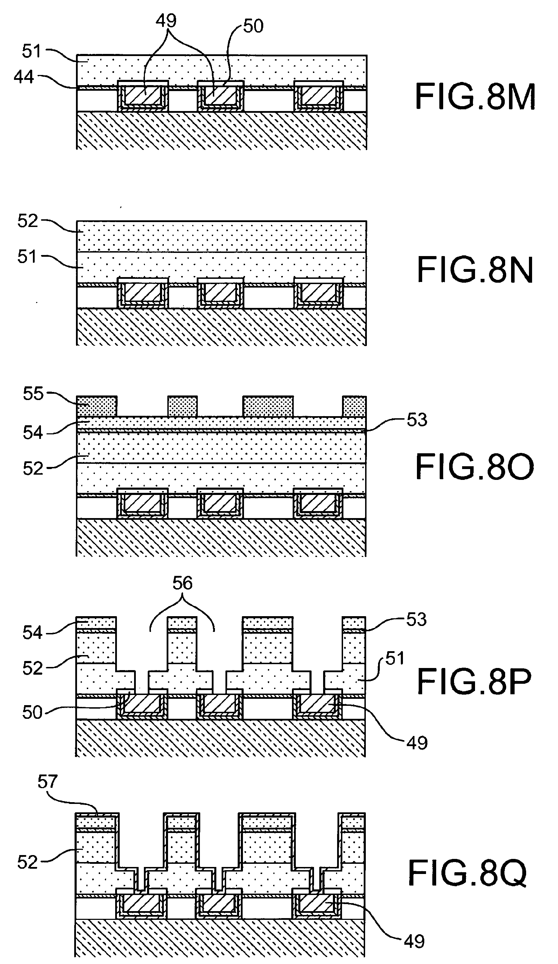

La figure 8M montre la structure obtenue précédemment avec, sur les lignes de cuivre 49, une couche de protection 50 servant de barrière de diffusion auto-alignée, en alliage de CoWB, CoWP ou CoWP/B (dépôt en solution aqueuse) ou de CuSiN (dépôt par un traitement plasma). Ensuite, une couche 51 en matériau diélectrique de type cité juste ci-dessus est déposée.

Sur la couche de matériau diélectrique 51, on dépose ensuite une couche de matériau sacrificiel 52, par exemple en SiO₂ (voir la figure 8N).

Après le dépôt de la couche sacrificielle 52, une couche de membrane 53 en matériau poreux ou non poreux de type SiC, d'épaisseur pouvant aller jusqu'à 60 nm, est déposée sur la couche sacrificielle 52. On dépose ensuite une couche de masque dur 54 (de type TiN ou carbone amorphe). On procède ensuite à la fabrication d'un masque 55 en vue de réaliser la structure double damascène (voir la figure 8O). Les ouvertures du masque 55 sont positionnées pour permettre la formation de vias jusqu'au premier niveau de connexions.

On procède ensuite à la gravure de la structure pour former les vias. Une légère surgravure du matériau constituant la couche 51 est prévue pour procurer une ouverture sur chaque ligne 49 concernée. Ainsi, des ouvertures 56 sont réalisées dans les couches 54, 53 et 52 avec un prolongement dans la couche 51 et la couche de protection 50 (voir la figure 8P).

On procède ensuite au dépôt d'une couche 57 de matériau poreux à la solution d'attaque de la couche sacrificielle 52. Cette couche 57 recouvre toute la surface libre de la structure jusqu'à la surface des lignes 49 révélée à l'étape précédente (voir la figure 8Q).

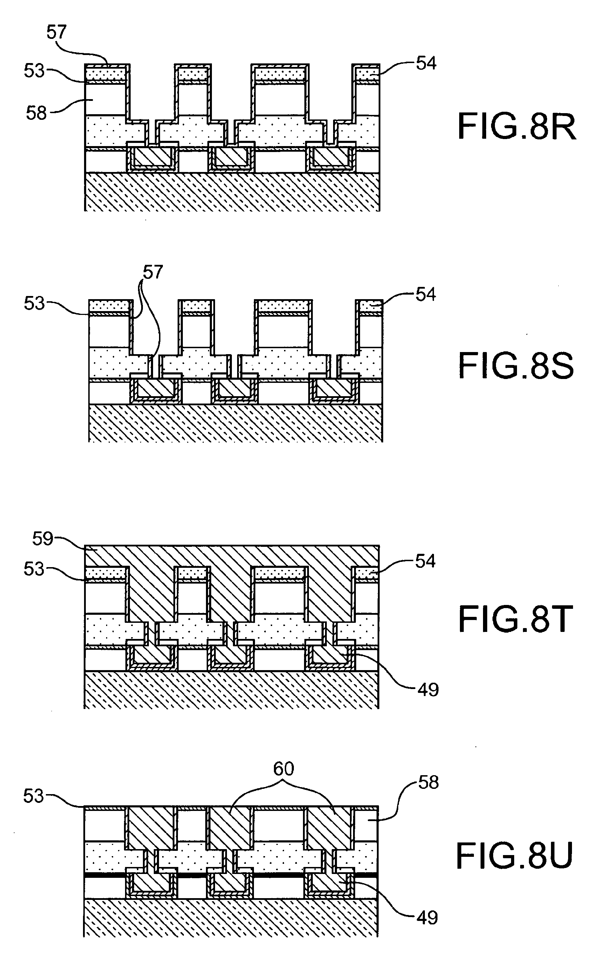

On procède ensuite au retrait du matériau sacrificiel 52 pour obtenir des cavités d'air au deuxième niveau de métallisation (voir la figure 8R).

On procède ensuite à l'élimination des parties de la couche 57 situées sur des sommets (parties horizontales), alors que les parties de la couche 57 situées sur les flancs sont préservées (voir la figure 8S).

Une couche de cuivre 59 est uniformément déposée sur la structure obtenue à l'étape précédente (voir la figure 8T). Elle assure un contact électrique avec les lignes 49 qu'il est prévu de contacter.

Un polissage mécano-chimique est ensuite réalisé (voir la figure 8U) pour individualiser les traversées 60 prenant contact avec les lignes 49. Le polissage élimine la couche de masque dur 54 subsistante. On procède aussi à l'élimination des parties de la couche de membrane 53 présentes uniquement sur les traversées 60 de façon à conserver les cavités d'air 58. La structure est alors prête pour la réalisation d'un niveau supplémentaire si nécessaire.

## Revendications

1. Procédé de fabrication d'une structure d'interconnexions électriques de type damascène pour un circuit intégré, comprenant au moins un niveau d'interconnexions, constitué de conducteurs électriques disposés sur un substrat et séparés entre eux par des cavités d'air, une couche de matériau électriquement isolant recouvrant le niveau d'interconnexions, le procédé comprenant les étapes consistant à :
- déposer une couche de matériau sacrificiel (41) sur le substrat (40),
- graver la couche de matériau sacrificiel (41) selon un motif correspondant aux conducteurs électriques,
- déposer, sur la surface gravée de la couche de matériau sacrificiel, une couche de membrane (43) en matériau perméable à un agent d'attaque permettant de décomposer le matériau sacrificiel (41),
- décomposer le matériau sacrificiel (41) au moyen de l'agent d'attaque, moyennant quoi des cavités d'air (46) sont formées à la place du matériau sacrificiel décomposé,
- former les conducteurs électriques (49) dans le motif de gravure pour obtenir des conducteurs électriques séparés par les cavités d'air (46),
- déposer une couche de matériau électriquement isolant (51) pour recouvrir le niveau d'interconnexions obtenu.

2. Procédé selon la revendication 1, comprenant en outre une étape consistant à déposer, avant l'étape de gravure du matériau sacrificiel (41), une couche de consolidation de membrane (44) en un matériau plus dense que la couche de membrane (43), qui est gravé lors de l'étape de gravure et qui n'est pas décomposé par l'agent d'attaque.

3. Procédé selon la revendication 2, comprenant en outre une étape consistant à déposer, avant l'étape de gravure du matériau sacrificiel (41), une couche d'un matériau masque (45) sur la couche de consolidation de membrane (44).

4. Procédé selon l'une des revendications 2 ou 3, comprenant, après l'étape de dépôt de la couche de membrane (43) et avant l'étape de formation des conducteurs électriques, une étape consistant à éliminer les parties de la couche de membrane (43) situées au fond des zones gravées et sur les parties non gravées de la couche de matériau sacrificiel (41).

5. Procédé selon l'une quelconque des revendications 2 à 4, dans lequel l'étape de formation des conducteurs électriques (49) comprend :
- une étape de dépôt d'une couche d'un matériau électriquement conducteur (48) avec remplissage du motif de gravure,
- une étape de polissage mécano-chimique menée jusqu'à révéler la couche de consolidation de membrane.

## Patentansprüche

1. Verfahren zur Herstellung einer Struktur elektrischer Verbindungen vom Damaszener-Typ für einen integrierten Schaltkreis, die mindestens eine Ebene von Verbindungen umfasst, die aus elektrischen Leitern besteht, die auf einem Substrat angeordnet sind und durch Luftzwischenräume voneinander getrennt sind, wobei eine Schicht aus elektrisch isolierendem Material die Ebene von Verbindungen abdeckt, wobei das Verfahren die in Folgendem bestehenden Schritte umfasst:
- Abscheiden einer Schicht aus Opfermaterial (41) auf dem Substrat (40),
- Ätzen der Schicht aus Opfermaterial (41) gemäß einem Motiv, das den elektrischen Leitern entspricht,
- Abscheiden einer Membranschicht (43) aus für ein Beizmittel durchlässigem Material auf der geätzten Fläche der Schicht aus Opfermaterial, was das Zersetzen des Opfermaterials (41) ermöglicht,
- Zersetzen des Opfermaterials (41) mittels des Beizmittels, wodurch Luftzwischenräume (46) anstelle des zersetzten Opfermaterials gebildet werden,
- Bilden der elektrischen Leiter (49) in dem Ätzmotiv, um elektrische Leiter zu erhalten, die durch die Luftzwischenräume (46) getrennt sind,
- Abscheiden einer Schicht aus elektrisch isolierendem Material (51), um die erhaltene Ebene von Verbindungen abzudecken.

2. Verfahren nach Anspruch 1, das außerdem einen Schritt umfasst, der in dem Abscheiden einer Membranstabilisierungsschicht (44) aus einem Material, das dichter als die Membranschicht (43) ist, vor dem Schritt des Ätzens des Opfermaterials (41) besteht, wobei die Membranstabilisierungsschicht (44) während des Ätzschritts geätzt wird und von dem Beizmittel nicht zersetzt wird.

3. Verfahren nach Anspruch 2, das außerdem einen Schritt umfasst, der in dem Abscheiden einer Schicht aus Maskenmaterial (45) auf der Membranstabilisierungsschicht (44) vor dem Schritt des Ätzens des Opfermaterials (41) besteht.

4. Verfahren nach einem der Ansprüche 2 oder 3, das nach dem Schritt des Abscheidens der Membranschicht (43) und vor dem Schritt des Bildens elektrischer Leiter einen Schritt umfasst, der in dem Entfernen der Teile der Membranschicht (43) besteht, die sich auf dem Boden geätzter Zonen und auf den nicht geätzten Teilen der Schicht aus Opfermaterial (41) befinden.

5. Verfahren nach einem beliebigen der Ansprüche 2 bis 4, wobei der Schritt des Bildens elektrischer Leiter (49) Folgendes umfasst:
- einen Schritt des Abscheidens einer Schicht aus einem elektrischen leitenden Material (48) mit Ausfüllen des Ätzmotivs,
- einen Schritt des Gleitschleifens, das durchgeführt wird, bis die Membranstabilisierungsschicht freigelegt wird.

## Claims

1. Method for manufacturing a structure of electrical interconnections of the damascene type for an integrated circuit, comprising at least one level of interconnections, consisting of electrical conductors arranged on a substrate and separated from one another by air cavities, a layer of electrically isolating material covering the level of interconnections, the method comprising steps consisting of:
- depositing a layer of sacrificial material (41) on the substrate (40),
- etching the layer of sacrificial material (41) according to a pattern corresponding to the electrical conductors,
- depositing, on the etched surface of the layer of sacrificial material, a layer of membrane (43) in material permeable to an attack agent capable of breaking down the sacrificial material (41),
- breaking down the sacrificial material by means of the attack agent, which is how air cavities (46) are formed in place of the broken down sacrificial material,
- forming the electrical conductors (49) in the etched pattern so as to obtain electrical conductors separated by the air cavities (46),
- depositing a layer of electrically isolating material (51) so as to cover the level of interconnections obtained.

2. Method according to claim 1, comprising also a step consisting of depositing, before the step of etching the sacrificial material (41), a membrane consolidation layer (44) in a material more dense than the layer of membrane (43), which is etched during the etching step and which is not broken down by the attack agent.

3. Method according to claim 2, comprising also a step consisting of depositing, before the step of etching the sacrificial material (41), a layer of mask material (45) on the membrane consolidation layer (44).

4. Method according to either one of claims 2 and 3, comprising, after the step of depositing the layer of membrane (43) and before the step of forming the electrical conductors, a step consisting of eliminating the parts of the layer of membrane (43) located in the bottom of the etched zones and on the unetched parts of the layer of sacrificial material (41).

5. Method according to any one of claims 2 to 4, in which the step of forming the electrical conductors (49) comprises:
- a step of depositing a layer of an electrically conducting material (48) with filling of the etched pattern,
- a mechanical-chemical polishing step performed until the membrane consolidation layer is revealed.
